# EUROPEAN PATENT APPLICATION

(11) **EP 4 296 401 A1**
(43) Date of publication of application: **27.12.2023**
(21) Application number: 22305917.1
(22) Date of filing: 24.06.2022
(51) Int. Cl.: C23C 14/00, C23C 14/10, C23C 14/24, C23C 14/30, C23C 14/48, C23C 14/50, B29D 11/00, G02B 7/02

(54) **SET COMPRISING A PHYSICAL VAPOR DEPOSITION MACHINE AND AN OBSTRUCTION DEVICE, METHOD FOR COATING AND OBSTRUCTION DEVICE**

(71) Applicant: Essilor International, 94220 Charenton-Le-Pont (FR)
(72) Inventor: HENKY, Francis, 21800 Chevigny-Saint-Sauveur (FR); MILDEBRATH, Mark, 75012 Paris (FR)
(74) Representative: Korakis-Ménager, Sophie

(57) **Abstract**

Set comprising a physical vapor deposition machine and an obstruction device. The physical vapor deposition machine comprises a vacuum container, an ion beam gun and a support member. The support member comprises at least one hole, the at least one hole is intended to receive a substrate, a shape of the substrate has sensibly a shape of the at least one hole. The ion beam gun is configured to generate an ion beam toward the support member. The obstruction device is configured to obstruct a gap between the at least one hole and the substrate when the substrate is placed in the at least one hole and the obstruction device is placed on the substrate.

## Description

### Technical field

Various aspects of this disclosure generally relate to the field of obstruction devices usable in a physical vapor deposition machine and the field of method for coating a substrate.

### Background information and prior art

The coating on a substrate, for example anti-reflective coating, is produced using a physical vapor deposition machine also known as vacuum evaporation equipment. The substrate on which the coating is applied can be an ophthalmic lens or a semi-finished lens blank that could have been previously covered with a hard coat resin. These machines make it possible to deposit the different layers composing the anti-reflective coating by evaporation of a material. This evaporation is realized by a material evaporation device. The physical vapor deposition machine also comprises an ion beam gun, which will allow the preparation of the surface of the lens before the deposition of the materials. This preparation is also known as Ion Pre-Cleaning (IPC) or cleaning. This preparation is generally realized by argon ion bombardment.

Generally, the substrate is placed in one of the holes of a support member. A gap can exist between the substrate and the support member. This gap is a problem because the ions and possibly the vapor, can go through this gap during the ion beam generation and possibly the evaporation, and then have an impact on the lens surface that is not supposed to be exposed. This phenomenon is called retro-diffusion. The retro-diffusion can create quality issues on the substrate for example lack of adhesion of the anti-reflective coating, color inhomogeneity of the coating and low top coat performance.

There is a need for a device and method allowing the elimination of the retro-diffusion phenomenon during the coating of the substrate.

### Summary

The following presents a simplified summary in order to provide a basic understanding of various aspects of this disclosure. This summary is not an extensive overview of all contemplated aspects and is intended to neither identify key or critical elements of all aspects nor delineate the scope of any or all aspects. The sole purpose is to present some concepts of one or more aspects in a simplified form as a prelude to the more detailed description that is presented later.

One aspect of this disclosure is a set comprising a physical vapor deposition machine and an obstruction device. The physical vapor deposition machine comprises a vacuum container, an ion beam gun and a support member. The support member comprises at least one hole, the at least one hole is intended to receive a substrate, a shape of the substrate has sensibly a shape of the at least one hole. The ion beam gun is configured to generate an ion beam toward the support member. The obstruction device is configured to obstruct a gap between the at least one hole and the substrate when the substrate is placed in the at least one hole and the obstruction device is placed on the substrate.

Another aspect of this disclosure is a method for coating a substrate. The method comprises a step of placing the substrate in a hole of a support member of a physical vapor deposition machine, a step of placing an obstruction device on the substrate to obstruct a gap between the hole and the substrate and a step of generating an ion beam from an ion beam gun located under the support member.

Another aspect of this disclosure is an obstruction device. The obstruction device is configured to be used in a physical vapor deposition machine. The physical vapor deposition machine comprises a vacuum container, an ion beam gun and a support member. The support member comprises at least one hole, the at least one hole is intended to receive a substrate. A shape of the substrate has sensibly a shape of the at least one hole. The ion beam gun is configured to generate an ion beam toward the support member. The obstruction device is configured to obstruct a gap between the at least one hole and the substrate when the substrate is placed in the at least one hole and the obstruction device is placed on the substrate.

### Description of the drawings

For a more complete understanding of the description provided herein and the advantages thereof, reference is now made to the brief descriptions below, taken in connection with the accompanying drawings and detailed description, wherein like reference numerals represent like parts.
Figure 1 represents a physical vapor deposition machine.
Figure 2 represents a crucible assembly.
Figure 3-a represents a substrate and a support member without an obstruction device.

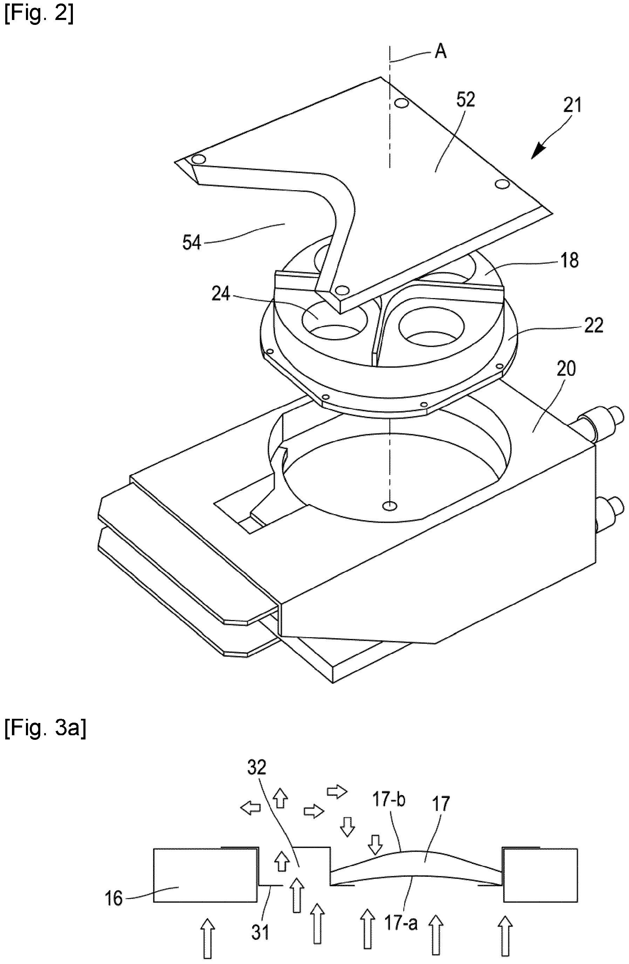

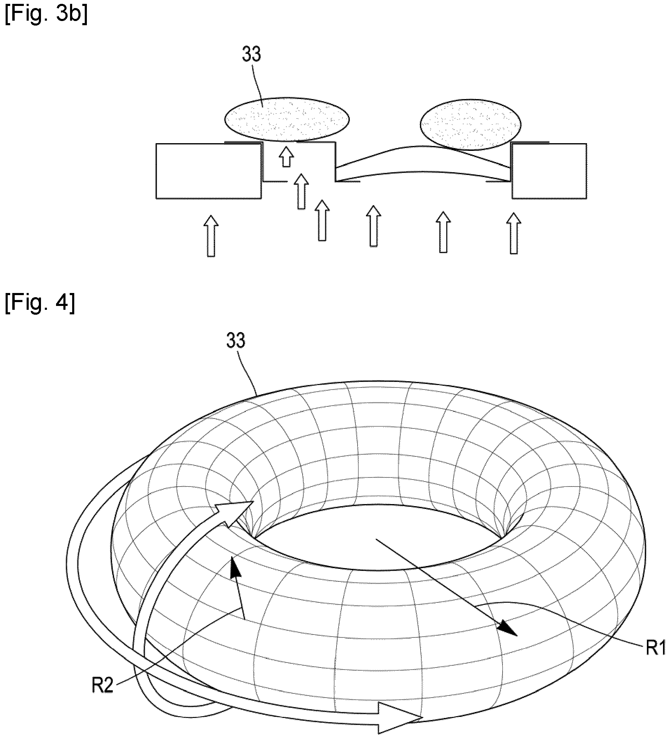

Figure 3-b represents a substrate and a support member with an obstruction device.
Figure 4 represents in another way the obstruction device.

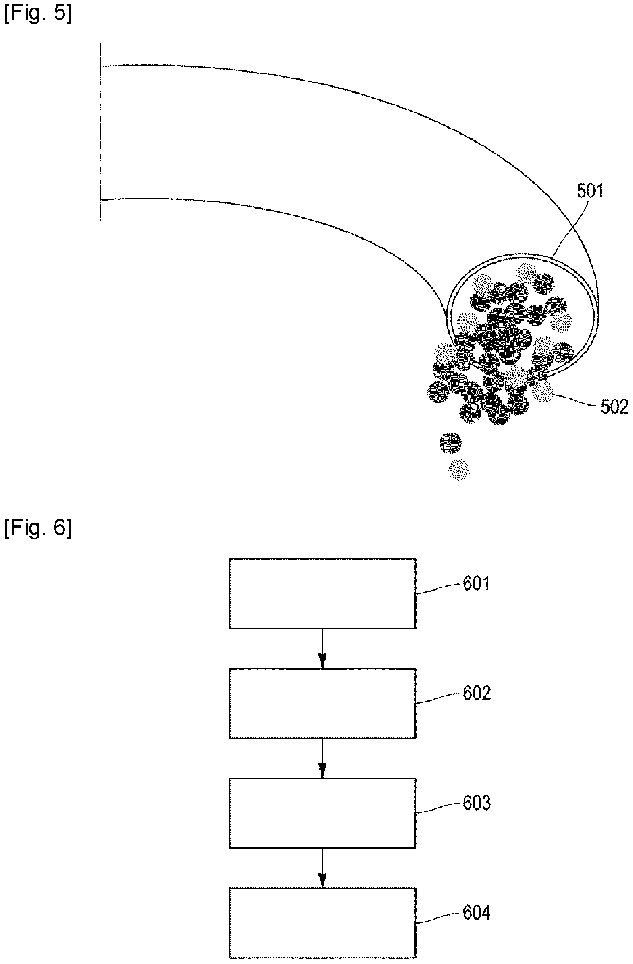

Figure 5 represents an exploded view of the obstruction device.
Figure 6 represents a method for coating the substrate.

### Detailed description of embodiments

The detailed description set forth below in connection with the appended drawings is intended as a description of various possible embodiments and is not intended to represent the only embodiments in which the concepts described herein may be practiced. The detailed description includes specific details for the purpose of providing a thorough understanding of various concepts. However, it will be apparent to those skilled in the art that these concepts may be practiced without these specific details. In some instances, well-known structures and components are shown in block diagram form in order to avoid obscuring such concepts.

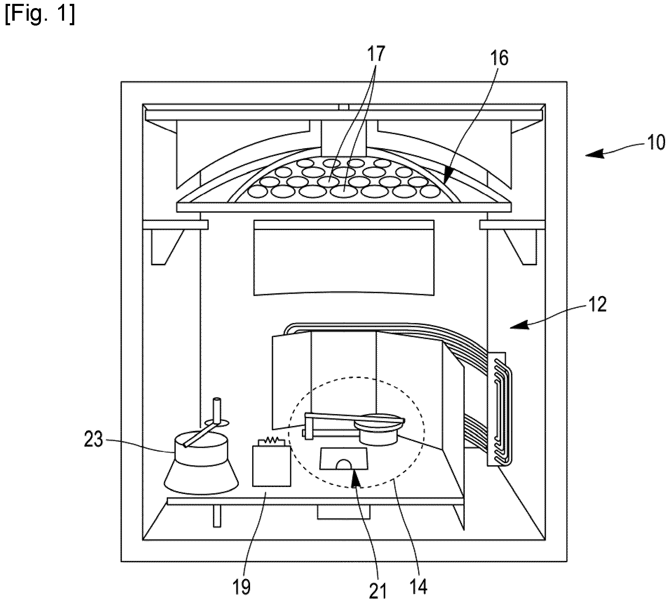

The figure 1 represents a physical vapor deposition machine 10.

The physical vapor deposition machine 10 comprises a vacuum container 12, a material evaporation device 14, an ion beam gun 19 and a support member 16.

The vacuum container 12 can be selectively put under vacuum.

The ion beam gun 19 can also be protected by a shutter 23. In figure 1 the shutter 23 is open and the ion beam gun 19 can generate the ion beam.

The support member 16 comprises a plurality of holes. Each hole is intended to receive a substrate 17. The support member 16, as represented in figure 1, can be a carrousel forming a bell.

The substrate 17 can be for example an ophthalmic lens, a semi-finished lens blank or a semi-finished lens blank covered with a hard coat resin. A shape of the substrate 17 has sensibly a shape of the hole.

The material evaporation device 14 and the ion beam gun 19 are located at the center of the vacuum container 12 and under the support member 16.

The ion beam gun 19 is an instrument that generates a beam of ions with various energy distribution characteristics depending on the design of the ion gun. The ion beam is extracted from a plasma that has been confined within a volume. Ions of a particular energy are extracted, accelerated, and in some cases collimated and/or focused. The ion beam gun 19 is composed of a plasma source, and can also have an extraction grid structure and a collimation or lensing structure. The plasma can be made up of an inert or reactive gas (e.g. N+ and O+) or an easily condensable substance (e.g. C+ and B+). The plasma can be formed from molecules that contain the substance which will form the beam, in which case, these molecules must be fragmented then ionized (e.g. H and CH4 can together be fragmented and ionized to create a beam). In some cases, the ion source delivers an ion beam consisting of a distribution of energies that is a function of the voltage applied to the anode of the source. Sources of the end-hall type design for example do not utilize ion focusing elements and as such can deliver higher ion currents (but at lower energies).

The material evaporation device 14 comprises a crucible assembly 21 and an electron beam gun. The crucible assembly 21 is configured to receive the material. The electron beam gun is configured to bombard electrons to the material, to evaporate the material and diffuse the vapor. The material is metal oxides and/or silica.

The crucible assembly 21, as represented in the figure 2, comprises a crucible 18 configured to receive material to be vaporized, a support 20 and a base 22 for connecting the crucible 18 to the support 20. The crucible 18 and the base 22 are shown in contact with each other in a connected position.

Crucible 18 comprises a plurality of cavities 24 wherein a material to be vaporized is received. The material may be received in a removable container disposed in one or more cavities 24 to ease the material replacement and cleaning operation. The cavities 24 are formed on the crucible upper surface. In other words, cavities 24 form a blind hole within the crucible 18 opening onto the crucible upper surface 26. More generally, crucible 18 is disk-shaped and the cavities 24 are preferably arranged in a circular configuration on the crucible 18 upper surface.

The support 20 also comprises a driving device configured to drive in rotation the base 22 around a rotational axis A. The rotary motion is then transmitted to the crucible 18 by the base 22. Rotating the crucible 18 around a rotational axis A allows to change the position of the cavities 24 and then to place a predetermined cavity 24 in front of the electron beam gun. This rotation may be performed using a rotation platform onto which the base 22 is disposed. The base 22 is configured to rotate the crucible 18 around the rotational axis A when connected to the crucible 18. In other words, the base 22 which is fixed to the support 20 forms a rotating carousel to rotate the crucible 18. The circular configuration of the cavities 24 is centered on the rotational axis A so that the rotation of the crucible 18 allows to move the cavities 24 around the rotational axis A. This allows to place a predetermined cavity 24 and thus a predetermined material in front of the electron beam gun. A controller is also provided to control the driving device and to thereby control which cavity 24 of the crucible 18 is disposed in front of the electron beam.

The crucible assembly 21 may further comprise a crucible cover 52 intended to be disposed above the crucible 18 to cover at least one of the cavities 24. The crucible cover 52 is removably mounted to the support 20 to remain stationary with regard to the crucible 18. The crucible cover 52 is configured to cover all the cavities 24 which are not in a position in which the material therein is in a position to be bombarded by the electron beam gun. In other words, the crucible cover 52 is configured to make only one cavity reachable by the electron beam. Alternatively, the crucible cover 52 may be configured to make a plurality of cavities 24 reachable by the electron beam when a plurality of cavities 24 are provided along a same radius with regard to the rotational axis A. The angular position of the crucible 18 allows to put a selected cavity 24 in front of the electron beam gun or in an operational position. The crucible cover 52 allows to protect all the other cavities 24 than the cavity 24 which is in this operational position. The crucible cover 52 defines a cavity cut-out or hole 54 which allows the crucible cover 52 not to cover the cavity 24 which is in said operational position. The crucible cover 52 is merely a plate with the cavity cut-out 54 formed at one side to face a cavity 24 of the crucible 18. cut-out may be opened so that the cut-out defines an external edge of the crucible cover 52 or closed so that the cut-out defines an internal edge of the crucible cover 52. The crucible cover 52 mainly extends perpendicularly to the rotational axis A when disposed above the crucible 18. The crucible cover 52 is preferably made in copper to improve heat dissipation.

In other words, the electron beam gun can evaporate different layers of materials. These different materials are arranged in the crucible 18 containing several cavities 24. The materials are evaporated one by one. The electron beam of the electron beam gun heats the cavities by the transfer of kinetic energy. The temperatures obtained can be very high. For example, the material can evaporate at a very high melting temperature (about 1500 ° C).

The working pressures are of the order of 10-3 Pascals. The vacuum chamber 12 is configured to achieve such low pressure. At this pressure, the average free path of an evaporated particle is higher than 10 cm. The evaporated molecules do not come in contact with the remaining air molecules, so the molecules do not lose energy and they are not altered. This allows for a clean deposit with a good deposit density on the lenses.

The figure 3-a represents the support member 16 and the substrate 17 placed in one of the holes of the support member 16. The substrate is placed in a cut or split ring 31. As presented in figure 3-a there is a gap 32 between the support member 16 and the substrate 17. The ions generated by the ion beam 19 gun and the vapor coming from the material evaporation device 14 reach a first side 17-a of the substrate 17 facing the ion beam gun 19 and/or the material evaporation device 14 when the substrate 17 is placed in the hole of the support member 16.

Because of the gap 32, ions and/or vapor can reach a second side 17-b of the substrate 17 opposed to the first side 17-a of the substrate 17. The ions or the vapor coming through this gap 32 will have an impact on the side of the substrate 17 that is not supposed to be exposed. This phenomenon is referred to as retro-diffusion and is represented by the arrows on figure 3-a. To fill this gap 32 an obstruction device 33 can be used. The figure 3-b represents the obstruction device 33 when it is placed on the substrate 17 when the substrate 17 is placed in the hole of the support member 17. In other words, to avoid the retro-diffusion, the obstruction device 33 is configured to obstruct the gap 32 between the support member 16 and the substrate 17 when obstruction device 33 is placed on the substrate 17.

The figure 4 represents an example of the obstruction device 33. In this example the obstruction device 33 has a shape following sensibly a torus of revolution. A major radius R1 of the torus of revolution is sensibly identical to a radius of the hole of the support member 16 or a radius of the substrate 17 to conform to an edge of the substrate 17. A minor radius R2 of the torus of revolution is configured to avoid a contact between a center of the obstruction device 33 and the substrate 17.

The major radius R1 is, for example, between 20 to 60 mm. The minor radius R2 is, for example, between 5 to 20 mm.

As presented in figure 5 in an exploded view, the obstruction device 33 can comprise a casing 501 forming an enclosed chamber. The casing 501 can be made of a soft and deformable material and the enclosed chamber can be filled with hard elements 502.

The soft and deformable material can be for example a textile and can be configured:
to avoid scratching one of the sides of the substrate 17 and
to avoid the ions crossing the soft and deformable material.

The hard elements 502 can be for example granules forming a granulate or balls. The size and material of the balls being chosen to allow the obstruction device to stay immobile during the generation of the ion beam. The sizes of the granules or balls are from diameter 0.5 mm to 5 mm. It can be a mix of granules of balls of a single diameter or of different diameters.

In other words, the obstruction device 33 closes the gap 32 between the support member 16 and the substrate 17. The obstruction device 33 has the advantages of being a lens-by-lens solution, in opposite to other solutions like:

Shield cover: a kind of blank that is installed on top of the sector with the lenses

Tissue (or cloth) cover: same concept as the previous one, but with a soft tissue or cloth.

Aluminum foil: protection of the substrate 17 by placing sheets or pieces of aluminum foil on the side of the substrate 17 not supposed to be coated.

The obstruction device 33 is especially useful when not all the substrate 17 are round, for example when some substrates 17 are a precal lens. The precal lenses are not round. To hold them, the use of specific cut or split rings must be used. These specific cut or split rings create a bigger gap.

The obstruction device 33 has also the advantage of being an individual lens protection that is quick to put in place.

The shape following sensibly a torus of revolution has the advantage of allowing the obstruction device to conform to the edge of the substrate 17, and to ensure a seal around the substrate 17 edge and the support member 16 so as to improve the effectiveness of the obstruction device 33.

The obstruction device 33 is placed by the operator before the anti-reflecting process on the substrate 17 and possibly mounted on cut or split ring 31.

The obstruction device 33 and the physical vapor deposition machine 10 formed together a set and can be used together.

The figure 6 represents a method for coating the substrate 17. The method comprises:
a step 601 of placing the substrate 17 in a hole of a support member 16 of the physical vapor deposition machine 10,
a step 602 of placing the obstruction device 33 on the substrate 17 to obstruct a gap 32 between the support member 16 and the substrate 17 and
a step of generating 603 an ion beam from an ion beam gun 19 located under the support member 16.

The method can also comprise a step 604 of diffusion, by the material evaporation device 14, of a vapor containing a material.

The step 601 of placing the substrate 17 in the hole can also comprise placing the substrate 17 in the on cut or split ring 31 and placing the on cut or split ring 31 comprising the substrate 17 in the hole.

## Claims

1. Set comprising a physical vapor deposition machine (10) and an obstruction device (33), the physical vapor deposition machine (10) comprising
a vacuum container (12),
an ion beam gun (19) and
a support member (16)
the support member (16) comprising at least one hole, the at least one hole being intended to receive a substrate (17), a shape of the substrate (17) having sensibly a shape of the at least one hole,
the ion beam gun (19) being configured to generate an ion beam toward the support member (16),
the obstruction device (33) being configured to obstruct a gap (32) between the at least one hole and the substrate when the substrate (17) is placed in the at least one hole and the obstruction device (33) is placed on the substrate (17).

2. The set according to the claim 1,
the ion beam gun (19) being under the support member (16),
a first side (17-a) of the substrate (17) facing the ion beam gun when the substrate (17) is placed in the at least one hole of the support member (16),
the obstruction device (33) being also configured to avoid the ions reaching a second side (17-b) of the substrate (17) opposed to the first side (17-a).

3. The set according to the claim 1 or 2,
the obstruction device (33) having a shape following sensibly a torus of revolution,
a major radius (R1) of the torus of revolution being sensibly identical to a radius of the at least one hole or a radius of the substrate (17) to conform to an edge of the substrate (17), a minor radius (R2) of the torus of revolution being configured to avoid a contact between a center of the obstruction device (33) and the substrate (17).

4. The set according to any one of the claims 1 to 3,
the obstruction device (33) comprising a casing forming an enclosed chamber,
the casing being made of a soft and deformable material,
the enclosed chamber being filled with hard elements.

5. The set according to the claim 4,
the soft and deformable material being a textile.

6. The set according to the claim 4 or 5,
the soft and deformable material being configured:
to avoid scratching a side of the substrate (17) and
to avoid the ions crossing the soft and deformable material.

7. The set according to any one of the claims 4 to 6,
the hard elements being balls or granules,
a size and a material of the balls or granules being chosen to allow the obstruction device (33) to stay immobile during the generation of the ion beam.

8. The set according to any one of the claims 2 to 7,
the physical vapor deposition machine (10) also comprising a material evaporation device (14),
the material evaporation device (14) being configured to diffuse a vapor comprising the material,
the material evaporation device (14) being under the support member (16),
the obstruction device (33) being also configured to avoid a diffusion of the vapor coming from the material evaporation device (14) to the second side (17-a) of the substrate (17).

9. The set according to the claim 8,
the material evaporation device (14) comprising
a crucible assembly (21) and
an electron beam gun
the crucible assembly (21) being configured to receive the material,
the electron beam gun being configured to bombard electrons to the material, to evaporate the material and diffuse the vapor.

10. The set according to the claim 8 or 9,
the material being metal oxides and/or silica.

11. The set according to any one of the claims 1 to 10,
the substrate (17) being an ophthalmic lens, a semi-finished lens blank or a semi-finished lens blank covered with a hard coat resin.

12. Method for coating a substrate (17),
the method comprising:
a step (601) of placing the substrate (17) in a hole of a support member (16) of a physical vapor deposition machine (10),
a step (602) of placing an obstruction device (33) on the substrate (17) to obstruct a gap between the hole and the substrate (33) and
a step (603) of generating an ion beam from an ion beam gun (19) located under the support member (16).

13. Method for coating a substrate according to the claim 12,
the method also comprising:
a step (604) of diffusion of a vapor containing a material.

14. Method for coating a substrate according to the claim 13,
the material being metal oxides and/or silica.

15. Obstruction device (33) configured to be used in a physical vapor deposition machine (10), the physical vapor deposition machine (10) comprising
a vacuum container (12),
an ion beam gun (19) and
a support member (16),
the support member (16) comprising at least one hole, the at least one hole being intended to receive a substrate, a shape of the substrate (33) having sensibly a shape of the at least one hole,
the ion beam gun (19) being configured to generate an ion beam toward the support member (16),
the obstruction device (33) being configured to obstruct a gap (32) between the at least one hole and the substrate (17) when the substrate is placed in the at least one hole and the obstruction device (33) is placed on the substrate (17).
